# EUROPEAN PATENT APPLICATION

(11) **EP 4 503 899 A1**
(43) Date of publication of application: **05.02.2025**
(21) Application number: 24191618.8
(22) Date of filing: 30.07.2024
(51) Int. Cl.: H10K 77/10, H10K 59/131

(54) **DISPLAY DEVICE AND METHOD OF MANUFACTURING THE SAME**

(30) Priority: 31.07.2023 KR 20230099327
(71) Applicant: Samsung Display Co., Ltd., Yongin-si, Gyeonggi-Do 17113 (KR)
(72) Inventor: Song, Si Joon, 17113 Giheung-gu, Yongin-si (KR); KANG, Youn Woong, 17113 Giheung-gu, Yongin-si (KR); KANG, Eui Jeong, 17113 Giheung-Gu, Yongin-si (KR); KOO, Min Sang, 17113 Giheung-gu, Yongin-si (KR); KIM, Tae Oh, 17113 Giheung-gu, Yongin-si (KR); NAM, Seok Hyun, 17113 Giheung-gu, Yongin-si (KR); PARK, Jeong Jin, 17113 Giheung-gu, Yongin-si (KR); LEE, Dong Hyun, 17113 Giheung-gu, Yongin-si (KR); LEE, Jae Hak, 17113 Giheung-gu, Yongin-si (KR)
(74) Representative: Dr. Weitzel & Partner

(57) **Abstract**

A display device includes a first substrate including an open portion, a first barrier insulating layer disposed on the first substrate and including a first contact hole overlapping the open portion, a first fan-out line disposed on the first barrier insulating layer, a pad part integrally formed with the first fan-out line and exposed through the open portion, a second substrate disposed on the first fan-out line, a connection part disposed on the second substrate and connected to the first fan-out line, a second fan-out line disposed on a layer between the first fan-out line and the connection part and connected to the connection part, a data line disposed on the same layer as the connection part and electrically connected to the second fan-out line, a flexible film including a lead electrode, and a contact part electrically connecting the lead electrode and the pad part.

## Description

### BACKGROUND

### 1. Technical Field

The present invention relates to a display device and a method of manufacturing the same.

### 2. Description of the Related Art

As an information society develops, the demand for a display device for displaying an image is increasing in various forms. For example, the display device has been applied to various electronic devices such as smartphones, digital cameras, laptop computers, navigation devices, and smart televisions. The display device may be a flat panel display device such as a liquid crystal display device, a field emission display device, or an organic light emitting display device. Among the flat panel display devices, the light emitting display device may include a light emitting element in which each of the pixels of a display panel may emit light by itself, thereby displaying an image without a backlight unit providing the light to the display panel.

### SUMMARY

Aspects of the present invention provide a display device capable of reducing manufacturing time and manufacturing cost by minimizing an area of a non-display area and simplifying a manufacturing process, and a method of manufacturing the same.

Aspects of the present invention are not restricted to those set forth herein. The above and other aspects of the present invention will become more apparent to one of ordinary skill in the art to which the present invention pertains by referencing the detailed description of the present invention given below.

The invention is defined by the independent claims. According to a first aspect of the invention, a display device includes a first substrate including an open portion, a first barrier insulating layer disposed on the first substrate and including a first contact hole overlapping the open portion, a first fan-out line disposed on the first barrier insulating layer, a pad part integrally formed with the first fan-out line and exposed through the open portion by being inserted into the first contact hole, a second substrate disposed on the first fan-out line, a connection part disposed on the second substrate and connected to the first fan-out line, a second fan-out line disposed on a layer between the first fan-out line and the connection part and connected to the connection part, a data line disposed on the same layer as the connection part and electrically connected to the second fan-out line to supply a data voltage, a flexible film disposed under the first substrate and including a lead electrode inserted into the open portion of the first substrate, and a contact part electrically connecting the lead electrode and the pad part by covering a lower surface of the lead electrode and a lower surface of the pad part.

In an embodiment, the lead electrode may protrude from one side of the flexible film, and the contact part covers the lower surface of the lead electrode protruding from the flexible film.

In an embodiment, the contact part may be formed by sintering conductive ink, metal paste, or metal organic decomposition ink including silver (Ag), copper (Cu), aluminum (Al), or chromium (Cr).

In an embodiment, the display device may further include a display area displaying an image, and a non-display area surrounding the display area. The flexible film may be disposed in the display area.

In an embodiment, the display device may further include a transistor including a drain electrode disposed on an active layer on the first fan-out line, a semiconductor area, a source electrode, and a gate electrode disposed on the active layer. The data line may supply a data voltage to the transistor.

In an embodiment, the display device may further include a power line disposed on the same layer as the data line to supply a power voltage to the transistor.

In an embodiment, the display device may further include a connection electrode disposed on the same layer as the data line and electrically connected to the transistor, and a pixel electrode disposed on the connection electrode and connected to the connection electrode to receive a driving current from the transistor.

In an embodiment, the display device may further include a transistor layer including a transistor electrically connected to the data line, a light emitting element layer disposed on the transistor layer and including a light emitting element, and an encapsulation layer covering an upper surface and side surfaces of the light emitting element layer.

In an embodiment, the first substrate and the second substrate may include a polyimide or a polymer resin.

According to a second aspect of the invention, a display device includes a first substrate including an open portion, a first barrier insulating layer disposed on the first substrate and including a first contact hole overlapping the open portion, a pad part inserted into the first contact hole and exposed through the open portion, a first fan-out line disposed on the first barrier insulating layer and integrally formed with the pad part, a second substrate disposed on the first fan-out line, a second fan-out line disposed on the second substrate and electrically connected to the first fan-out line, a transistor disposed on the first fan-out line and electrically connected to the second fan-out line, a flexible film disposed under the first substrate and inserted into the open portion of the first substrate, and a lead electrode protruding from one side of the flexible film and including a portion that does not overlap the flexible film.

In an embodiment, the display device may further comprise a contact part electrically connecting the lead electrode and the pad part by covering a portion of the lead electrode that does not overlap the flexible film and one surface of the pad part.

In an embodiment, the contact part may be formed by sintering conductive ink, metal paste, or metal organic decomposition ink including silver (Ag), copper (Cu), aluminum (Al), or chromium (Cr).

In an embodiment, the display device may further include a data line disposed on the transistor to supply a data voltage to the transistor, and a power line disposed on the same layer as the data line to supply a power voltage to the transistor.

In an embodiment, the display device may further include a connection electrode disposed on the same layer as the data line and electrically connected to the transistor, and a pixel electrode disposed on the connection electrode and connected to the connection electrode to receive a driving current from the transistor.

According to a third aspect of the invention, a method of manufacturing a display device includes preparing a first substrate, forming a first barrier insulating layer including a first contact hole on the first substrate, forming a first fan-out line disposed on the first barrier insulating layer and a pad part integrally formed with the first fan-out line and inserted into the first contact hole, forming a second substrate on the pad part, forming a second fan-out line disposed on the second substrate, forming a connection part disposed on the second fan-out line to electrically connect the first and second fan-out lines, forming an open portion exposing the pad part by etching a lower portion of the first substrate, inserting a lead electrode of a flexible film into the open portion and fixing the lead electrode to one surface of the pad part, and forming a contact part electrically connecting the pad part and the lead electrode by covering a portion of the pad part and a portion of the lead electrode.

In an embodiment, the forming of the contact part may include printing conductive ink, metal paste, or metal organic decomposition ink including silver (Ag), copper (Cu), aluminum (Al), or chromium (Cr) on the open portion of the first substrate, and sintering the conductive ink, metal paste, or metal organic decomposition ink.

In an embodiment, the forming of the contact part may further include separating the sintered conductive ink, metal paste, or metal organic decomposition ink into a plurality of contact parts through a laser patterning process.

In an embodiment, the sintering of the conductive ink, metal paste, or metal organic decomposition ink may include aggregating metal particles by applying heat generated by light pulse or laser.

In an embodiment, the forming of the contact part may include printing conductive ink, metal paste, or metal organic decomposition ink on the open portion of the first substrate by performing a squeeze process using a mask including a plurality of holes, and sintering the conductive ink, metal paste, or metal organic decomposition ink.

In an embodiment, the size and spacing of the plurality of holes may be determined by the size and spacing of the pad part.

According to an embodiment, the display device may include a flexible film and a display driver disposed on a lower side of a first substrate, a first fan-out line disposed on a lower side of a second substrate, and a second fan-out line disposed on the second substrate, thereby minimizing an area of a non-display area. In addition, according to an embodiment, as the lead electrode and the pad part are fixed and electrically connected through the contact part using the metal paste, manufacturing time and manufacturing cost may be reduced by simplifying the manufacturing process without using ultrasonic bonding or thermocompression bonding.

However, the effects of the embodiments are not restricted to only one embodiment set forth herein. The above and other effects of the embodiments will become more apparent to one of daily skill in the art to which the embodiments pertain.

### BRIEF DESCRIPTION OF THE DRAWINGS

The above and other aspects and features of the present invention will become more apparent by describing in detail embodiments thereof with reference to the attached drawings, in which:
FIG. 1 is a plan view illustrating a display device, according to an embodiment;
FIG. 2 is a cross-sectional view illustrating a display device, according to an embodiment;
FIG. 3 is a cross-sectional view of the display device of FIG. 1 taken along line I-I' of FIG. 1, according to an embodiment;
FIG. 4 is a bottom view of a display device, according to an embodiment;
FIG. 5 is an expanded bottom view of a portion of the display device, according to an embodiment;
FIG. 6 is a view illustrating a pad part, a fan-out line, a power line, and a data line in the display device, according to an embodiment;
FIG. 7 is another cross-sectional view of the display device of FIG. 1 taken along line I-I' of FIG. 1, according to an embodiment;
FIG. 8 is a cross-sectional view illustrating an example of a process of manufacturing a display device, according to an embodiment;
FIG. 9 is a cross-sectional view illustrating an example of a process of manufacturing a display device, according to an embodiment;
FIG. 10 is a cross-sectional view illustrating an example of a process of manufacturing a display device, according to an embodiment;
FIG. 11 is a cross-sectional view illustrating an example of a process of manufacturing a display device, according to an embodiment;
FIG. 12 is a cross-sectional view illustrating another example of a process of manufacturing a display device, according to an embodiment; and
FIG. 13 is a plan view illustrating a mask used in the process of manufacturing the display device of FIG. 12, according to an embodiment.

### DETAILED DESCRIPTION OF THE EMBODIMENTS

In the following description, for the purposes of explanation, numerous specific details are set forth in order to provide a thorough understanding of various embodiments or implementations of the invention. It is apparent, however, that various embodiments may be practiced without these specific details. In other instances, structures and devices are shown in block diagram form in order to avoid unnecessarily obscuring various embodiments. Further, various embodiments may be different, but do not have to be exclusive nor limit the scope of the invention. For example, specific shapes, configurations, and characteristics of an embodiment may be used or implemented in other embodiments without departing from the scope of the invention.

Unless otherwise specified, the illustrated embodiments are to be understood as providing features of varying detail of some ways in which the invention may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements.

Further, the X-axis, the Y-axis, and the Z-axis are not limited to three axes of a rectangular coordinate system, and thus the X-, Y-, and Z- axes, and may be interpreted in a broader sense. For example, the X-axis, the Y-axis, and the Z-axis may be perpendicular to one another, or may represent different directions that are not perpendicular to one another.

For the purposes of this invention, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, ZZ, or the like. As used herein, the term "and/or" includes any and all combinations of one or more of the associated listed items.

Moreover, although the terms "first," "second," and the like may be used herein to describe various types of elements, these elements should not be limited by these terms. These terms are used to distinguish one element from another element. Thus, a first element discussed below could be termed a second element without departing from the teachings of the invention.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "about" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature, and the shapes of these regions may not reflect actual shapes of regions of a device and, as such, are not necessarily intended to be limiting.

Additionally, some embodiments are described and illustrated in the accompanying drawings in terms of functional blocks, units, parts, and/or modules. Those skilled in the art will appreciate that these blocks, units, parts, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, parts, and/or modules being implemented by microprocessors or other similar hardware, they may be programmed and controlled using software (e.g., microcode) to perform various functions discussed herein and may optionally be driven by firmware and/or software. It is also contemplated that each block, unit, part, and/or module may be implemented by dedicated hardware, or as a combination of dedicated hardware to perform some functions and a processor (e.g., one or more programmed microprocessors and associated circuitry) to perform other functions. Also, each block, unit, part, and/or module of some embodiments may be physically separated into two or more interacting and discrete blocks, units, parts, and/or modules without departing from the scope of the invention. Further, the blocks, units, parts, and/or modules of some embodiments may be physically combined into more complex blocks, units, parts, and/or modules without departing from the scope of the invention.

Unless otherwise defined or implied herein, all terms (including technical and scientific terms) used herein have the same meaning as commonly understood by those skilled in the art to which this invention pertains. It will be further understood that terms, such as those defined in commonly used dictionaries, should be interpreted as having a meaning that is consistent with their meaning in the context of the relevant art and the invention, and should not be interpreted in an ideal or excessively formal sense unless clearly so defined herein.

Hereinafter, detailed embodiments are described with reference to the accompanying drawings.

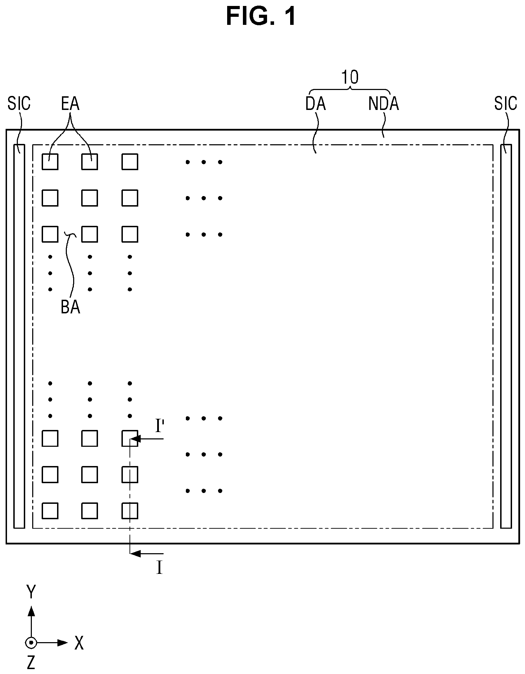

FIG. 1 is a plan view illustrating a display device, according to an embodiment.

In an embodiment and referring to FIG. 1, a display device 10 may be applied to portable electronic devices such as a mobile phone, a smartphone, a tablet personal computer (PC), a mobile communication terminal, an electronic notebook, an electronic book, a portable multimedia player (PMP), navigation, and an ultra mobile PC (UMPC). In another embodiment, the display device 10 may be applied to a display unit of a television, a laptop computer, a monitor, a billboard, or the Internet of Things (IOT). As still another embodiment, the display device 10 may be applied to a wearable device such as a smart watch, a watch phone, a glasses-type display, and a head mounted display (HMD).

In an embodiment, the display device 10 may be formed in a planar shape similar to a quadrangle. For example, in the display device 10, a corner where a side directed in an X-axis direction and a side directed in a Y-axis direction meet may be rounded to have a predetermined curvature or may be formed at a right angle. The planar shape of the display device 10 is not limited to the quadrangle, and may be formed similarly to other polygons, circles, or ovals.

In an embodiment, the display device 10 may include a display area DA and a non-display area NDA. The display area DA may include a plurality of pixels to display an image. Each of the plurality of pixels may include an organic light emitting diode (LED) including an organic light emitting layer, a quantum dot LED including a quantum dot light emitting layer, an inorganic LED including an inorganic semiconductor, or a micro-LED. Hereinafter, it will be mainly described that each of the plurality of pixels includes an organic light emitting diode, but the invention is not limited thereto.

In an embodiment, the plurality of pixels may be arranged along a plurality of rows and columns in the display area DA. Each of the plurality of pixels may include a light emitting area EA defined by a pixel defining film or a bank, and may emit light having a predetermined peak wavelength through the light emitting area EA. The light emitting area EA may be an area in which light generated by a light emitting element of the display device 10 is emitted to the outside of the display device 10.

In an embodiment, the display area DA of the display device 10 may include a light blocking area BA surrounding a plurality of light emitting areas EA. The light blocking area BA may prevent the light emitted from the light emitting areas EA from being mixed.

In an embodiment, the non-display area NDA may be disposed around the display area DA to surround the display area DA and may not display an image. The non-display area NDA may include a scan driver SIC supplying a scan signal to the display area DA. The scan driver SIC may be disposed on the left and right sides of the non-display area NDA. The scan driver SIC may generate the scan signal based on a scan control signal. The scan control signal may include a start signal, a clock signal, and a power supply voltage, but is not limited thereto. The scan driver SIC may supply the scan signal to scan lines of the display area DA according to the set order.

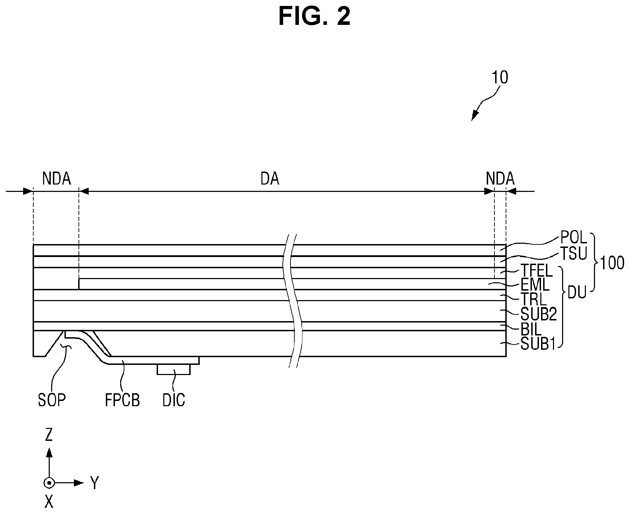

FIG. 2 is a cross-sectional view illustrating a display device, according to an embodiment.

In an embodiment and referring to FIG. 2, a display panel 100 may include a display unit DU, a touch sensing unit TSU, and an optical member POL. The display unit DU may include a first substrate SUB1, a barrier insulating layer BIL, a second substrate SUB2, a transistor layer TRL, a light emitting element layer EML, and an encapsulation layer TFEL.

In an embodiment, the first substrate SUB1 may support the display device 10. The first substrate SUB1 may be a base substrate or a base member. The first substrate SUB1 may be a flexible substrate that may be bent, folded, or rolled. For example, the first substrate SUB1 may include an insulating material such as a polymer resin, for example, polyimide PI, but is not limited thereto. In another embodiment, the first substrate SUB1 may be a rigid substrate including a glass material.

In an embodiment, the barrier insulating layer BIL may be disposed on the first substrate SUB 1. The barrier insulating layer BIL may include an inorganic film capable of preventing permeation of air or moisture. For example, the barrier insulating layer BIL may include at least one of a silicon nitride layer, a silicon oxynitride layer, a silicon oxide layer, a titanium oxide layer, an aluminum oxide layer, and an amorphous silicon layer, but is not limited thereto.

In an embodiment, the second substrate SUB2 may be disposed on the barrier insulating layer BIL. The second substrate SUB2 may be a base substrate or a base member. The second substrate SUB2 may be a flexible substrate that may be bent, folded, or rolled. For example, the second substrate SUB2 may include an insulating material such as a polymer resin, for example, polyimide PI, but is not limited thereto.

In an embodiment, the transistor layer TRL may be disposed on the second substrate SUB2. The transistor layer TRL may include a plurality of transistors constituting a pixel circuit of pixels. The transistor layer TRL may include scan lines, data lines, and power lines connected to the pixels. Each of the transistors may include a semiconductor area, a source electrode, a drain electrode, and a gate electrode. For example, when the scan driver is formed on one side of the non-display area NDA of the display panel 100, the scan driver may include transistors.

In an embodiment, the transistor layer TRL may be disposed in the display area DA and the non-display area NDA. The transistors of each of the pixels, the scan lines, the data lines, and the power lines of the transistor layer TRL may be disposed in the display area DA. The transistors of the scan driver SIC may be disposed in the non-display area NDA.

In an embodiment, the light emitting element layer EML may be disposed on the transistor layer TRL. The light emitting element layer EML may include a plurality of light emitting elements in which a pixel electrode, a light emitting layer, and a common electrode are sequentially stacked to emit light, and a pixel defining film defining pixels. The plurality of light emitting elements of the light emitting element layer EML may be disposed in the display area DA.

In an embodiment, the light emitting layer EML may be an organic light emitting layer including an organic material. The light emitting layer EML may include a hole transporting layer, an organic light emitting layer, and an electron transporting layer. When the pixel electrode receives a predetermined voltage through the transistor of the transistor layer TRL and the common electrode receives a cathode voltage, holes move to the organic light emitting layer through the hole transporting layer, and electrons move to the organic light emitting layer through the electron transporting layer, so that the holes and the electrons may combine with each other in the organic light emitting layer to emit light. In an embodiment, the pixel electrode may be an anode electrode and the common electrode may be a cathode electrode, but the invention is not limited thereto.

In another embodiment, the plurality of light emitting elements may include a quantum dot light emitting diode including a quantum dot light emitting layer, an inorganic light emitting diode including an inorganic semiconductor, or a micro light emitting diode.

In an embodiment, the encapsulation layer TFEL may cover an upper surface and side surfaces of the light emitting element layer EML, and may protect the light emitting element layer EML. The encapsulation layer TFEL may include at least one inorganic film and at least one organic film for encapsulating the light emitting element layer EML.

In an embodiment, the touch sensing unit TSU may be disposed on the encapsulation layer TFEL. The touch sensing unit TSU may include a plurality of touch electrodes for sensing a user's touch in a capacitance method, and touch lines supplying touch driving signals to the plurality of touch electrodes. In an embodiment, the touch sensing unit TSU may sense the user's touch in a mutual capacitance method or a self-capacitance method.

In an embodiment, the plurality of touch electrodes of the touch sensing unit TSU may be disposed in a touch sensor area overlapping the display area DA. The touch lines of the touch sensing unit TSU may be disposed in a touch peripheral area overlapping the non-display area NDA.

In an embodiment, the optical member POL may be disposed on the touch sensing unit TSU. The optical member POL may be attached onto the touch sensing unit TSU by using an optically clear adhesive (OCA) film or an optically clear resin (OCR). For example, the optical member POL may include a linear polarizer and a phase retardation film, where the phase retardation film may be a λ/4 plate (quarter-wave plate). The phase retardation film and the linear polarizer may be sequentially stacked on the touch sensing unit TSU. The optical member POL may prevent color distortion due to external light reflection by reducing reflected light by external light.

In an embodiment, the first substrate SUB1 may include an open portion SOP. The open portion SOP of the first substrate SUB1 may be etched from a lower surface of the first substrate SUB1 to penetrate through an upper surface of the first substrate SUB1. For example, a width of a lower portion of the first substrate SUB 1 may be greater than a width of an upper portion of the first substrate SUB1. During the process of manufacturing the display device 10, a pad part provided on the barrier insulating layer BIL may be exposed by the open portion SOP of the first substrate SUB1. The pad part may be electrically connected to a display driver DIC through a flexible film FPCB inserted into the open portion SOP.

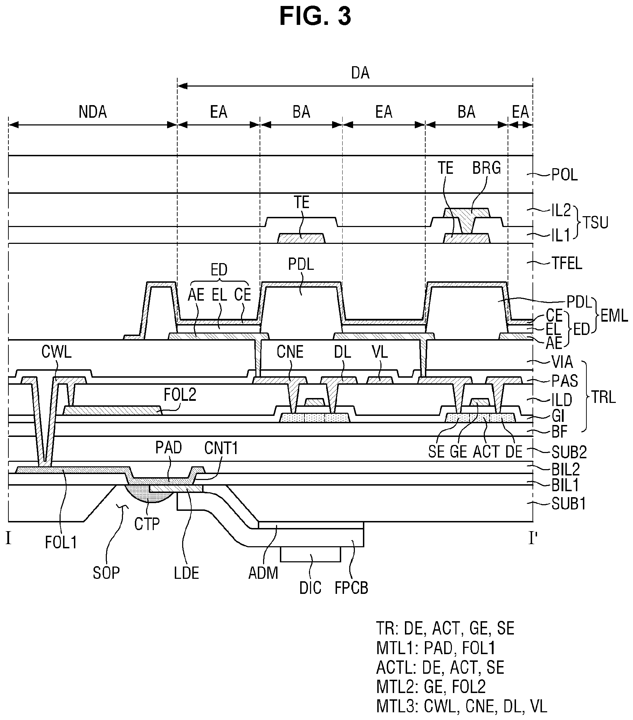

In an embodiment, the flexible film FPCB may be disposed on a lower side of the first substrate SUB1. A portion of the flexible film FPCB may be inserted into the open portion SOP of the first substrate SUB1 and electrically connected to the pad part, and another portion of the flexible film FPCB may be disposed on the lower surface of the first substrate SUB1 through a support member, in particular a support member ADM in FIG. 3. The flexible film FPCB may support the display driver DIC. The flexible film FPCB may transmit a signal and a voltage of the display driver DIC to the transistor layer TRL. The flexible film FPCB may supply scan control signals to the scan driver SIC.

In an embodiment, the display driver DIC may be mounted on the flexible film FPCB. The display driver DIC may be an integrated circuit (IC). The display driver DIC may convert digital video data into an analog data voltage based on a data control signal received from a timing controller (not illustrated) and may supply the digital video data to the data line of the display area DA through the flexible film FPCB. The display driver DIC may supply a power voltage received from a power supply unit (not illustrated) to the power line of the display area DA through the flexible film FPCB. The display device 10 may include the flexible film FPCB and the display driver DIC disposed in the display area DA on the lower side of the first substrate SUB1, thereby minimizing an area of the non-display area NDA.

FIG. 3 is an example of a cross-sectional view of the display device of FIG. 1 taken along line I-I' of FIG. 1, according to an embodiment.

In an embodiment and referring to FIG. 3, the display area DA of the display device 10 may include a plurality of light emitting areas EA. Each of the light emitting areas EA may be an area in which light generated by a light emitting element ED is emitted to the outside of the display device 10.

In an embodiment, the display device 10 may include a first substrate SUB 1, a first barrier insulating layer BIL1, a first metal layer MTL1, a second barrier insulating layer BIL2, a second substrate SUB2, a transistor layer TRL, a light emitting element layer EML, an encapsulation layer TFEL, a touch sensing unit TSU, an optical member POL, a flexible film FPCB, and a display driver DIC.

In an embodiment, the first substrate SUB1 may support the display device 10. The first substrate SUB1 may be a base substrate or a base member. The first substrate SUB1 may be a flexible substrate that may be bent, folded, or rolled. For example, the first substrate SUB1 may include an insulating material such as a polymer resin, for example, polyimide PI, but is not limited thereto. In another embodiment, the first substrate SUB1 may be a rigid substrate including a glass material.

In an embodiment, the first substrate SUB1 may include an open portion SOP. The open portion SOP of the first substrate SUB1 may be etched from a lower surface of the first substrate SUB1 to penetrate through an upper surface of the first substrate SUB1. For example, a width of a lower portion of the first substrate SUB1 may be greater than a width of an upper portion of the first substrate SUB 1. In other words, the open portion SOP may have a trapezoid cross section. During the process of manufacturing the display device 10, a pad part PAD may be exposed by the open portion SOP of the first substrate SUB1. The pad part PAD may be electrically connected to the display driver DIC through a lead electrode LDE of the flexible film FPCB inserted into the open portion SOP.

In an embodiment, the first barrier insulating layer BIL1 may be disposed on the first substrate SUB1. The first barrier insulating layer BIL1 may include an inorganic film capable of preventing permeation of air or moisture. For example, the first barrier insulating layer BIL1 may include at least one of a silicon nitride layer, a silicon oxynitride layer, a silicon oxide layer, a titanium oxide layer, an aluminum oxide layer, and an amorphous silicon layer, but is not limited thereto.

In an embodiment, the first barrier insulating layer BIL1 may include a first contact hole CNT1. The first contact hole CNT1 may overlap the open portion SOP of the first substrate SUB1. The first contact hole CNT1 may be smaller than the open portion SOP of the first substrate SUB1. The first contact hole CNT1 may be etched from an upper surface of the first barrier insulating layer BIL1 to penetrate through a lower surface of the first barrier insulating layer BIL1. In an embodiment, a width of an upper portion of the first contact hole CNT1 may be greater than a width of a lower portion of the first contact hole CNT1. In other words, the first contact hole CNT1 may have a trapezoid cross section, in particular mirrored to the cross section of the open portion SOP.

In an embodiment, the first metal layer MTL1 may be disposed on the first barrier insulating layer BIL1. The first metal layer MTL1 may include a pad part PAD and a first fan-out line FOL1. The first metal layer MTL1 may be formed as a single layer or multiple layers including at least one of molybdenum (Mo), aluminum (Al), chromium (Cr), gold (Au), silver (Ag), titanium (Ti), nickel (Ni), palladium (Pd), indium (In), neodymium (Nd), and copper (Cu).

In an embodiment, the pad part PAD may be integrally formed with the first fan-out line FOL1 and inserted into the first contact hole CNT1. The pad part PAD may electrically connect the flexible film FPCB and the first fan-out line FOL1. The pad part PAD may be exposed by the open portion SOP of the first substrate SUB1. A portion of the pad part PAD may be in direct contact with the lead electrode LDE of the flexible film FPCB, and another portion of the pad part PAD may be electrically connected to the lead electrode LDE of the flexible film FPCB through a contact part CTP.

The contact part CTP may have a hemispherical shape. The high of the contact part CTP may be smaller than a thickness of the first substrate SUB1. The diameter of the contact part CTP may be smaller than the open portion SOP.

In an embodiment, the first fan-out line FOL1 may electrically connect the pad part PAD and a connection part CWL. The first fan-out line FOL1 may be electrically connected to the data line DL or the power line VL of the display area DA or the scan driver SIC of the non-display area NDA through the connection part CWL and a second fan-out line FOL2. The data line DL and the power line VL of the display area DA may be electrically connected to the transistor TR, and the scan driver SIC may generate a scan signal. Therefore, the first fan-out line FOL1 may supply the data voltage or the power voltage received from the display driver DIC to a transistor TR of a pixel through the connection part CWL and the second fan-out line FOL2, and may supply the scan control signal received from the flexible film FPCB to the scan driver SIC through the connection part CWL and the second fan-out line FOL2. The display device 10 may include the first fan-out line FOL1 disposed on a lower side of the second substrate SUB2 and the second fan-out line FOL2 disposed on the second substrate SUB2, thereby minimizing an area of the non-display area NDA.

In an embodiment, the second barrier insulating layer BIL2 may be disposed on the first barrier insulating layer BIL1 and the first metal layer MTL1. The second barrier insulating layer BIL2 may include an inorganic film capable of preventing permeation of air or moisture. For example, the second barrier insulating layer BIL2 may be formed as a double layer including silicon oxide (SiOx) and amorphous silicon (a-Si). The second barrier insulating layer BIL2 may include amorphous silicon (a-Si), thereby increasing adhesion between upper and lower layers and improving peeling defects.

In an embodiment, the second substrate SUB2 may be disposed on the second barrier insulating layer BIL2. The second substrate SUB2 may be a base substrate or a base member. The second substrate SUB2 may be a flexible substrate that may be bent, folded, or rolled. For example, the second substrate SUB2 may include an insulating material such as a polymer resin, for example, polyimide PI, but is not limited thereto.

In an embodiment, the transistor layer TRL may be disposed on the second substrate SUB2. The transistor layer TRL includes a buffer layer BF, an active layer ACTL, a gate insulating layer GI, a second metal layer MTL2, an interlayer insulating layer ILD, a third metal layer MTL3, a passivation layer PAS, and a via layer VIA.

In an embodiment, the buffer layer BF may be disposed on the second substrate SUB2. The buffer layer BF may include an inorganic material capable of preventing permeation of air or moisture. The buffer layer BF may include a plurality of inorganic films that are alternately stacked. The buffer layer BF may include a contact hole through which the connection part CWL penetrates.

In an embodiment, the active layer ACTL may be disposed on the buffer layer BF. The active layer ACTL may include a semiconductor area ACT, a drain electrode DE, and a source electrode SE of the transistor TR. The semiconductor area ACT may overlap a gate electrode GE in a thickness direction (Z-axis direction), and may be insulated from the gate electrode GE by the gate insulating layer GI. The drain electrode DE and the source electrode SE may be formed by making a material of the semiconductor area ACT conductive. The transistor TR may constitute a pixel circuit of each of the plurality of pixels.

In an embodiment, the gate insulating layer GI may be disposed on the active layer ACTL and the buffer layer BF. The gate insulating layer GI may insulate the semiconductor area ACT and the gate electrode GE of the transistor TR. The gate insulating layer GI may include a contact hole through which each of the connection part CWL, the connection electrode CNE, and the data line DL penetrates.

In an embodiment, the second metal layer MTL2 may be disposed on the gate insulating layer GI. The second metal layer MTL2 may include the gate electrode GE of the transistor TR and the second fan-out line FOL2. The gate electrode GE may overlap the semiconductor area ACT with the gate insulating layer GI interposed therebetween. The gate electrode GE may receive the scan signal from the scan line. For example, the second metal layer MTL2 may be formed as a single layer or multiple layers including at least one of molybdenum (Mo), aluminum (Al), chromium (Cr), gold (Au), silver (Ag), titanium (Ti), nickel (Ni), palladium (Pd), indium (In), neodymium (Nd), and copper (Cu).

In an embodiment, the second fan-out line FOL2 may be connected to the connection part CWL. The second fan-out line FOL2 may be electrically connected to the data line DL or the power line VL of the display area DA, or the scan driver SIC of the non-display area NDA. The data line DL and the power line VL of the display area DA may be electrically connected to the transistor TR, and the scan driver SIC may generate a scan signal. Therefore, the second fan-out line FOL2 may supply the data voltage or the power voltage received through the pad part PAD and the first fan-out line FOL1 to the transistor TR of the pixel, and supply the scan control signal to the scan driver SIC. The display device 10 may include the first fan-out line FOL1 disposed on a lower side of the second substrate SUB2 and the second fan-out line FOL2 disposed on the second substrate SUB2, thereby minimizing an area of the non-display area NDA.

In an embodiment, the interlayer insulating layer ILD may be disposed on the second metal layer MTL2. The interlayer insulating layer ILD may be disposed on the second and third metal layers MTL2 and MTL3. The interlayer insulating layer ILD may include a contact hole through which each of the connection part CWL, the connection electrode CNE, and the data line DL penetrates.

In an embodiment, the third metal layer MTL3 may be disposed on the interlayer insulating layer ILD. The third metal layer MTL3 may include a connection part CWL, a connection electrode CNE, a data line DL, and a power line VL. The connection part CWL, the connection electrode CNE, the data line DL, and the power line VL may be formed of the same material on the same layer. For example, the third metal layer MTL3 may be formed as a single layer or multiple layers including at least one of molybdenum (Mo), aluminum (Al), chromium (Cr), gold (Au), silver (Ag), titanium (Ti), nickel (Ni), palladium (Pd), indium (In), neodymium (Nd), and copper (Cu).

In an embodiment, the connection part CWL may electrically connect the first and second fan-out lines FOL1 and FOL2. The connection part CWL may be inserted into a contact hole penetrating through the interlayer insulating layer ILD, the gate insulating layer GI, the buffer layer BF, the second substrate SUB2, and the second barrier insulating layer BIL2, and connected to the first fan-out line FOL1. The connection part CWL may be inserted into a contact hole penetrating through the interlayer insulating layer ILD and connected to the second fan-out line FOL2.

In an embodiment, the connection electrode CNE may electrically connect the source electrode SE of the transistor TR and the pixel electrode AE of the light emitting element ED. The connection electrode CNE may be inserted into a contact hole penetrating through the interlayer insulating layer ILD and the gate insulating layer GI and connected to the source electrode SE of the transistor TR. The connection electrode CNE may supply a driving current received from the pixel circuit to the light emitting element ED.

In an embodiment, the data line DL may extend in the Y-axis direction in the display area DA. The data line DL may be inserted into a contact hole penetrating through the interlayer insulating layer ILD and the gate insulating layer GI and connected to the drain electrode DE of the transistor TR. The data line DL may supply the data voltage to the transistor TR.

In an embodiment, the power line VL may extend in the Y-axis direction in the display area DA. The power line VL may be electrically connected to the transistor TR or the light emitting element ED. For example, the power line VL may be a high potential line, a low potential line, or a sensing line, but is not limited thereto.

In an embodiment, the passivation layer PAS may be disposed on the third metal layer MTL3 and the interlayer insulating layer ILD. The passivation layer PAS may protect the transistor TR. The passivation layer PAS may include a contact hole through which the pixel electrode AE penetrates.

In an embodiment, the via layer VIA may be disposed on the passivation layer PAS. The via layer VIA may planarize an upper end of the transistor layer TRL. The via layer VIA may include an organic insulating material such as polyimide PI. The via layer VIA may include a contact hole through which the pixel electrode AE penetrates.

In an embodiment, the light emitting element layer EML may be disposed on the transistor layer TRL. The light emitting element layer EML may include a light emitting element ED and a pixel defining film PDL.

In an embodiment, the light emitting element ED may be disposed in the light emitting area EA on the via layer VIA. The light emitting element ED of each of the plurality of pixels may include a pixel electrode AE, a light emitting layer EL, and a common electrode CE. The pixel electrode AE may be disposed on the via layer VIA. The pixel electrode AE may overlap one of the plurality of light emitting areas EA defined by the pixel defining film PDL. For example, the pixel electrode AE may receive a driving current from the pixel circuit through the connection electrode CNE.

In an embodiment, the light emitting layer EL may be disposed on the pixel electrode AE. For example, the light emitting layer EL may be an organic light emitting layer made of an organic material, but is not limited thereto. When the light emitting layer EL corresponds to the organic light emitting layer, the pixel circuit of the pixel applies a predetermined voltage to the pixel electrode AE, and when the common electrode CE receives the common voltage or the cathode voltage, holes may move to the light emitting layer EL through the hole transporting layer, electrons may move to the light emitting layer EL through the electron transporting layer, and the holes and the electrons may combine with each other in the light emitting layer EL to emit light.

In an embodiment, the common electrode CE may be disposed on the light emitting layer EL. For example, the common electrode CE may be implemented in the form of an electrode common to all pixels without being divided for each of the plurality of pixels. The common electrode CE may be disposed on the light emitting layer EL in the plurality of light emitting areas, and may be disposed on the pixel defining film PDL in an area other than the plurality of light emitting areas.

In an embodiment, the pixel defining film PDL may be disposed in the light blocking area BA on the via layer VIA. The pixel defining film PDL may define a plurality of light emitting areas EA or a plurality of opening areas. The pixel defining film PDL may separate and insulate the pixel electrodes AE of the plurality of pixels from each other.

In an embodiment, the encapsulation layer TFEL may be disposed on the common electrode CE to cover the plurality of light emitting elements ED. The encapsulation layer TFEL may include at least one inorganic film to prevent oxygen or moisture from permeating into the plurality of light emitting elements ED. The encapsulation layer TFEL may include at least one organic film to protect the plurality of light emitting elements ED from foreign substances such as dust.

In an embodiment, the touch sensing unit TSU may be disposed on the encapsulation layer TFEL. The touch sensing unit TSU may include a touch electrode TE, a first insulating layer IL1, a bridge electrode BRG, and a second insulating layer IL2.

In an embodiment, the touch electrode TE may be disposed in the light blocking area BA on the encapsulation layer TFEL. The touch electrode TE may sense a user's touch in a capacitance method. For example, the touch sensing unit TSU may sense the user's touch in a mutual capacitance method formed between a plurality of touch electrodes TE, or a self-capacitance method formed on each of the plurality of touch electrodes TE. The touch electrode TE may be formed as a single layer made of molybdenum (Mo), titanium (Ti), copper (Cu), aluminum (Al), or indium tin oxide (ITO), or be formed as a stacked structure (Ti/Al/Ti) of aluminum and titanium, a stacked structure (ITO/Al/ITO) of aluminum and ITO, an APC alloy, and a stacked structure (ITO/APC/ITO) of an APC alloy and ITO.

In an embodiment, the first insulating layer IL1 may be disposed on the touch electrode TE and the encapsulation layer TFEL. The first insulating layer IL1 may have insulation and optical functions. In one embodiment, the first insulating layer IL1 may be an inorganic film including at least one of a silicon nitride layer, a silicon oxynitride layer, a silicon oxide layer, a titanium oxide layer, and an aluminum oxide layer. In another embodiment, the first insulating layer IL1 may include an organic film.

In an embodiment, the bridge electrode BRG may be disposed on the first insulating layer IL1. The bridge electrode BRG may be disposed on a different layer from the touch electrodes TE to electrically connect the touch electrodes TE disposed adjacent to each other.

In an embodiment, the second insulating layer IL2 may be disposed on the bridge electrode BRG and the first insulating layer IL1. The second insulating layer IL2 may have insulation and optical functions. The second insulating layer IL2 may be formed of the material illustrated in the first insulating layer II,1.

In an embodiment, the optical member POL may be disposed on the second insulating layer IL2. The optical member POL may be attached onto the touch sensing unit TSU by using an optically clear adhesive (OCA) film or an optically clear resin (OCR). For example, the optical member POL may include a linear polarizer and a phase retardation film, and the phase retardation film may be a λ/4 plate (quarter-wave plate). The phase retardation film and the linear polarizer may be sequentially stacked on the touch sensing unit TSU. The optical member POL may prevent color distortion due to external light reflection by reducing reflected light by external light.

In an embodiment, the flexible film FPCB may be disposed on a lower side of the first substrate SUB1. One side of the flexible film FPCB may be inserted into the open portion SOP of the first substrate SUB1 and electrically connected to the pad part PAD, and the other side of the flexible film FPCB may be disposed on the lower surface of the first substrate SUB1 using the support member ADM. For example, the support member ADM may support the flexible film FPCB by including at least one of a patterned film and a cover panel. The flexible film FPCB may include a lead electrode LDE disposed on an upper surface of one side thereof and inserted into the open portion SOP. The lead electrode LDE may protrude from one side of the flexible film FPCB, and a portion of the lead electrode LDE may not overlap the flexible film FPCB. In an embodiment, an adhesive layer (not illustrated) may be disposed between the lead electrode LDE and the pad part PAD to adhere the upper surface of the lead electrode LDE to a portion of the pad part PAD, and a portion of a lower surface of the lead electrode LDE may be electrically connected to another portion of the pad part PAD through the contact part CTP. In another embodiment, the upper surface of the lead electrode LDE may be in direct contact with a portion of the pad part PAD, and a portion of the lower surface of the lead electrode LDE may be electrically connected to another portion of the pad part PAD through the contact part CTP.

In an embodiment, the flexible film FPCB may support the display driver DIC disposed on a lower surface of the other side thereof. The lead electrode LDE may be electrically connected to the display driver DIC through a lead line (not illustrated) disposed on the lower surface of the flexible film FPCB. The other side of the flexible film FPCB may be connected to a source circuit board (not illustrated) on a lower side of the first substrate SUB1. The flexible film FPCB may transmit signals and voltages of the display driver DIC to the display device 10. The flexible film FPCB may supply scan control signals to the scan driver SIC.

In an embodiment, the contact part CTP may cover the lower surface of the lead electrode LDE protruding from the flexible film FPCB and the lower surface of the pad part PAD exposed through the open portion SOP. The contact part CTP may electrically connect the lead electrode LDE and the pad part PAD, and may stably fix the lead electrode LDE to the lower surface of the pad part PAD.

In an embodiment, the contact part CTP may be formed by low temperature sintering of conductive ink including nanoparticles and polymers. The nanoparticles may include nanoscale metal particles such as silver (Ag), copper (Cu), aluminum (Al), or chromium (Cr), and the polymer may include an acrylic resin or an epoxy resin, but the invention is not limited thereto. The conductive ink may include a polymer as a binder connecting metal particles, and the nanoparticles may be aggregated in close contact with each other through the sintering process. The contact part CTP may have conductivity by including the sintered nanoparticles.

In another embodiment, the contact part CTP may be formed by low temperature sintering of metal organic decomposition (MOD) ink. The metal organic decomposition ink may include a liquid metal organic decomposition material smaller than nanoparticles, and the liquid metal organic decomposition material may be changed into a metal material through a sintering process. Therefore, the contact part CTP may have conductivity.

In an embodiment, the contact part CTP may be formed by printing conductive ink or metal paste on the open portion SOP of the first substrate SUB1 using a silicon pad and then sintering conductive ink or metal paste using an intense pulsed light (IPL) or laser. Specific resistance of the contact part CTP may be lowered in the sintering process when the metal particles are brought into close contact with each other and aggregated by heat due to light pulse or laser.

In an embodiment, the display driver DIC may be mounted on the flexible film FPCB. The display driver DIC may be an integrated circuit (IC). The display driver DIC may convert digital video data into an analog data voltage based on a data control signal received from a timing controller (not illustrated) and may supply the digital video data to the data line DL of the display area DA through the flexible film FPCB. The display driver DIC may supply a power voltage received from a power supply unit (not illustrated) to the power line VL of the display area DA through the flexible film FPCB. The display device 10 may include the pad part PAD and the fan-out line FOL disposed on the first substrate SUB 1 and the flexible film FPCB and the display driver DIC disposed on the lower side of the first substrate SUB1, thereby minimizing an area of the non-display area NDA.

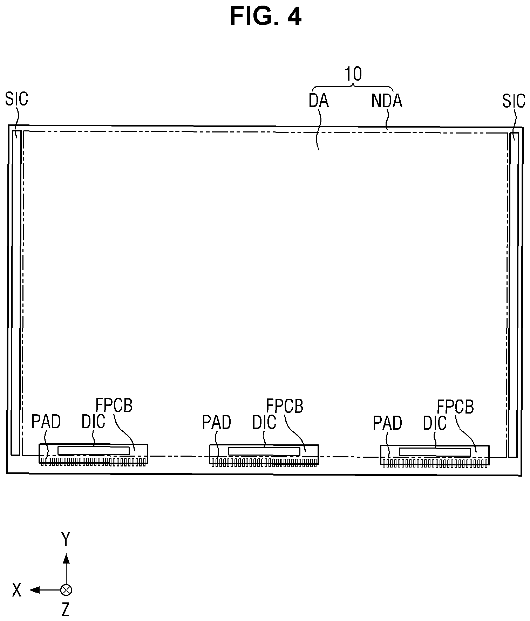

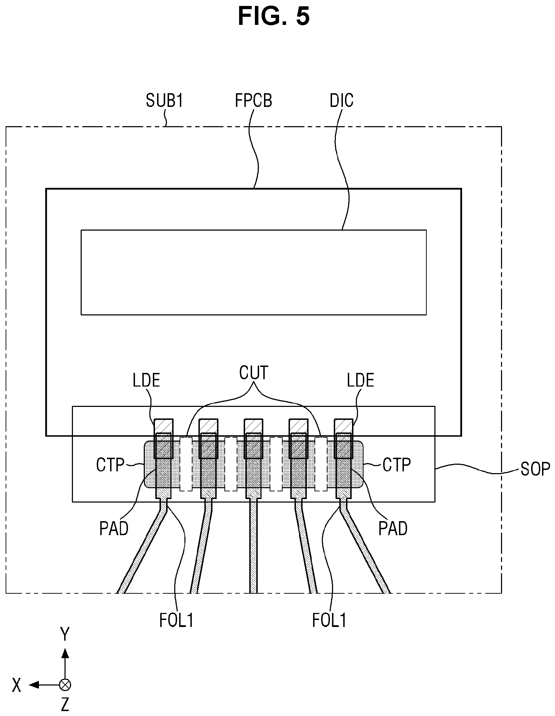

FIG. 4 is a bottom view illustrating a display device, according to an embodiment, and FIG. 5 is an enlarged bottom view illustrating a portion of the display device, according to an embodiment.

In an embodiment and referring to FIGS. 4 and 5, the pad part PAD may be disposed in the non-display area NDA.

In an embodiment, the adhesive layer may be disposed between the lead electrode LDE and the pad part PAD to bring a portion of the pad part PAD into contact with the lead electrode LDE of the flexible film FPCB, and another portion of the pad part PAD may be electrically connected to the lead electrode LDE of the flexible film FPCB through the contact part CTP. As another example, a portion of the pad part PAD may be in direct contact with the lead electrode LDE, and another portion of the pad part PAD may be electrically connected to the lead electrode LDE through the contact part CTP.

In an embodiment, the first fan-out line FOL1 may be integrally formed with the pad part PAD and may extend from the pad part PAD to an edge of the display device 10. The second fan-out line FOL2 may be electrically connected to the first fan-out line FOL1 and extend into the display area DA. In an embodiment, the first fan-out line FOL1 may extend in an opposite direction of the Y axis, and the second fan-out line FOL2 may extend in the Y axis direction, but are not limited thereto. The first fan-out line FOL1 may intersect the second fan-out line FOL2, but is not limited thereto. The first fan-out line FOL1 may be electrically connected to the data line DL and the power line VL of the display area DA or the scan driver SIC of the non-display area NDA through the connection part CWL and the second fan-out line FOL2.

In an embodiment, the flexible film FPCB may be disposed on a lower side of the first substrate SUB1. The flexible film FPCB may be disposed on an edge of the lower surface of the display device 10. The flexible film FPCB may supply data voltages, power voltages, and scan control signals, but is not limited thereto. The display driver DIC may be mounted on the flexible film FPCB. The display driver DIC may supply the data voltages and the power voltages to the display panel 100 through the flexible film FPCB.

In an embodiment, the sintered conductive ink or metal paste may cover the plurality of pad parts PAD and the plurality of lead electrodes LDE inserted into one open portion SOP at once, and a plurality of cutting portions CUT formed in the laser patterning process may separate the plurality of contact parts CTP. The contact part CTP may be spaced apart from adjacent contact parts CTP by the plurality of cutting portions CUT, and one contact part CTP may electrically connect one pad part PAD and one lead electrode LDE.

In another embodiment, the plurality of contact parts CTP may be formed by performing a squeeze process using a mask including a plurality of holes on the conductive ink or metal paste. In this case, the plurality of contact parts CTP may be spaced apart from each other according to a distance between the plurality of holes, and one contact part CTP may electrically connect one pad part PAD and one lead electrode LDE without a separate patterning process.

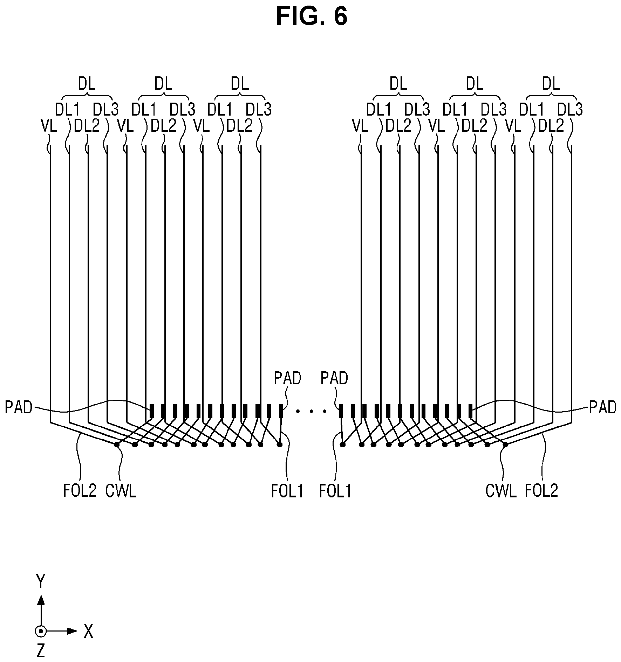

FIG. 6 is a view illustrating a pad part, a fan-out line, a power line, and a data line in the display device, according to an embodiment.

In an embodiment and referring to FIG. 6, the display area DA may include power lines VL and data lines DL.

In an embodiment, a plurality of power lines VL may extend in the second direction, in particular the Y-axis direction, and may be spaced apart from each other in the first direction, in particular the X-axis direction. Referring to FIG. 3, the power line VL may be disposed on the third metal layer MTL3 and extend in the second direction (Y-axis direction). The power line VL may be electrically connected to the pad part PAD through the second fan-out line FOL2 of the second metal layer MTL2 and the first fan-out line FOL1 of the first metal layer MTL1. The power line VL may intersect the first and second fan-out lines FOL1 and FOL2 in a plan view. The power line VL may receive a power voltage through the pad part PAD. Here, the power voltage may be a high potential voltage, a low potential voltage, a driving voltage, an initialization voltage, a reference voltage, or a bias voltage, but is not limited thereto.

In an embodiment, the data lines DL may include first to third data lines DL1, DL2, and DL3, respectively. The first to third data lines DL1, DL2, and DL3, respectively, may extend in the second direction, in particular the Y-axis direction, and may be spaced apart from each other in the first direction, in particular the X-axis direction. The first to third data lines DL1, DL2, and DL3, respectively, may supply first to third data voltages to the plurality of pixels. Referring to FIG. 3, the data line DL may be disposed on the third metal layer MTL3 and extend in the second direction, in particular the Y-axis direction. The data line DL may be electrically connected to the pad part PAD through the second fan-out line FOL2 of the second metal layer MTL2 and the first fan-out line FOL1 of the first metal layer MTL1. The data line DL may intersect the first and second fan-out lines FOL1 and FOL2, respectively, in a plan view. The data line DL may receive a data voltage through the pad part PAD.

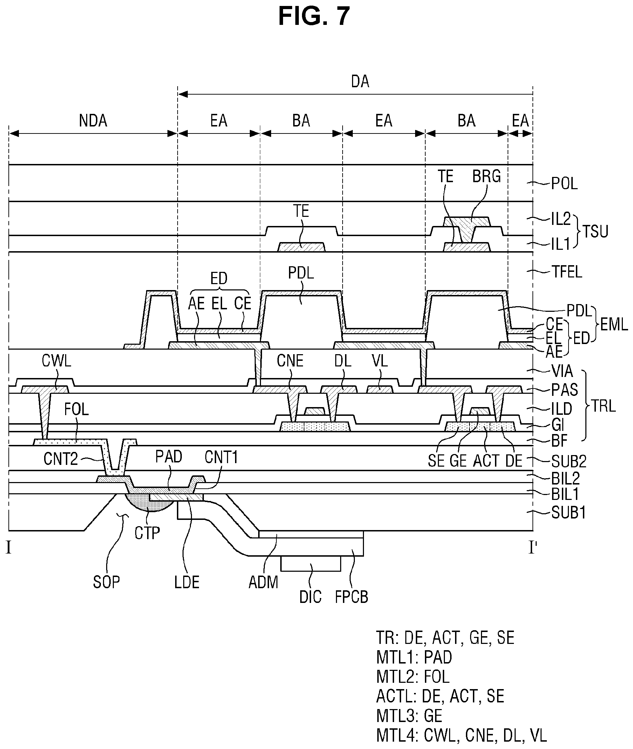

FIG. 7 is another embodiment of a cross-sectional view of the display device of FIG. 1 taken along line I-I' of FIG. 1, according to an embodiment. The display device of FIG. 7 has a configuration of a fan-out line FOL different from that of the display device of FIG. 3, and the same configurations as those described above will be briefly described or omitted.

In an embodiment and referring to FIG. 7, the display device 10 may include a first substrate SUB1, a first barrier insulating layer BII,1, a first metal layer MTL1, a second barrier insulating layer BIL2, a second substrate SUB2, a transistor layer TRL, a light emitting element layer EML, an encapsulation layer TFEL, a touch sensing unit TSU, an optical member POL, a flexible film FPCB, and a display driver DIC.

In an embodiment, the first metal layer MTL1 may be disposed on the first barrier insulating layer BII,1. The first metal layer MTL1 may include a pad part PAD. The first metal layer MTL1 may be formed as a single layer or multiple layers including at least one of molybdenum (Mo), aluminum (Al), chromium (Cr), gold (Au), silver (Ag), titanium (Ti), nickel (Ni), palladium (Pd), indium (In), neodymium (Nd), and copper (Cu).

In an embodiment, the pad part PAD may be inserted into the first contact hole CNT1. The pad part PAD may electrically connect the flexible film FPCB and the fan-out line FOL. The pad part PAD may be exposed by the open portion SOP of the first substrate SUB1. In an embodiment, an adhesive layer (not illustrated) may be disposed between the lead electrode LDE and the pad part PAD to adhere a portion of the pad part PAD to the lead electrode LDE of the flexible film FPCB, and another portion of the pad part PAD may be electrically connected to the lead electrode LDE of the flexible film FPCB through the contact part CTP. In another embodiment, the upper surface of the lead electrode LDE may be in direct contact with a portion of the pad part PAD, and a portion of the lower surface of the lead electrode LDE may be electrically connected to another portion of the pad part PAD through the contact part CTP.

In an embodiment, the transistor layer TRL may be disposed on the second substrate SUB2. The transistor layer TRL includes a second metal layer MTL2, a buffer layer BF, an active layer ACTL, a gate insulating layer GI, a third metal layer MTL3, an interlayer insulating layer ILD, a fourth metal layer MTL4, a passivation layer PAS, and a via layer VIA.

In an embodiment, the second metal layer MTL2 may be disposed on the second substrate SUB2. The second metal layer MTL2 may include the fan-out line FOL. The second metal layer MTL2 may be formed as a single layer or multiple layers including at least one of molybdenum (Mo), aluminum (Al), chromium (Cr), platinum (Pt), gold (Au), silver (Ag), titanium (Ti), nickel (Ni), palladium (Pd), indium (In), neodymium (Nd), tungsten (W), and copper (Cu).

In an embodiment, the fan-out line FOL may be inserted into the second contact hole CNT2 and be in contact with the pad part PAD. The fan-out line FOL may electrically connect the pad part PAD and the connection part CWL. The fan-out line FOL may be electrically connected to the data line DL or the power line VL of the display area DA, or the scan driver SIC of the non-display area NDA through the connection part CWL. The data line DL and the power line VL of the display area DA may be electrically connected to the transistor TR, and the scan driver SIC may generate a scan signal. Therefore, the fan-out line FOL may supply the data voltage or the power voltage received from the display driver DIC to the transistor TR of the pixel through the connection part CWL, and may supply the scan control signal received from the flexible film FPCB to the scan driver SIC through the connection part CWL. The display device 10 may include the fan-out line FOL disposed in the display area DA, thereby minimizing an area of the non-display area NDA.

In an embodiment, the third metal layer MTL3 may be disposed on the gate insulating layer GI. The third metal layer MTL3 may include a gate electrode GE of the transistor TR.

In an embodiment, the fourth metal layer MTL4 may be disposed on the interlayer insulating layer ILD. The fourth metal layer MTL4 may include a connection part CWL, a connection electrode CNE, a data line DL, and a power line VL.

In an embodiment, the connection part CWL may be inserted into a contact hole penetrating through the interlayer insulating layer ILD, the gate insulating layer GI, and the buffer layer BF and be connected to the fan-out line FOL. For example, the connection part CWL may be electrically connected to the data line DL to supply the data voltage to the transistor TR. The connection part CWL may be electrically connected to the power line VL to supply the power voltage to the transistor TR. The connection part CWL may be electrically connected to the scan driver SIC to supply the scan control signal to the scan driver SIC. Therefore, the connection part CWL may supply the data voltage or the power voltage received from the display driver DIC to the transistor TR of the pixel through the fan-out line FOL, and may supply the scan control signal received from the flexible film FPCB to the scan driver SIC. In other embodiments, the connection part CWL may be omitted or integrally formed with the data line DL or the power line VL.

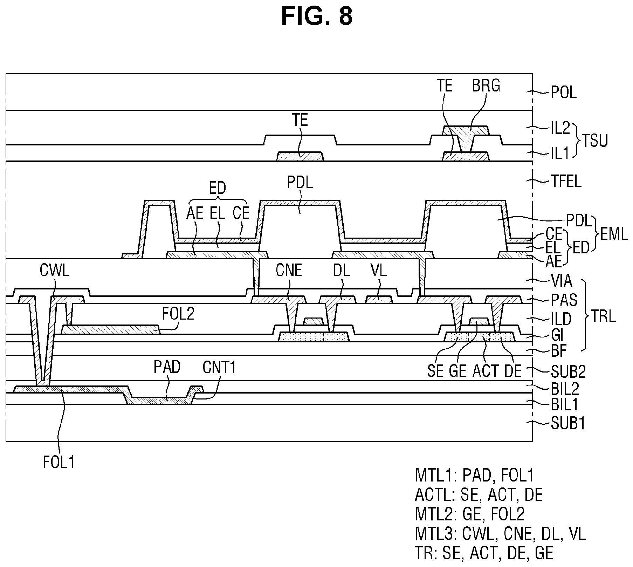

FIGS. 8 to 11 are cross-sectional views illustrating an example of a process of manufacturing a display device, according to an embodiment. Hereinafter, the same configuration as the configuration described above will be briefly described or omitted.

In an embodiment and referring to FIG. 8, the first substrate SUB1 may support the display device 10. The first substrate SUB1 may be a base substrate or a base member.

In an embodiment, the first barrier insulating layer BIL1 may be disposed on the first substrate SUB1. The first barrier insulating layer BIL1 may include an inorganic film capable of preventing permeation of air or moisture. The first barrier insulating layer BIL1 may include a first contact hole CNT1. The first contact hole CNT1 may be etched from an upper surface of the first barrier insulating layer BIL1 to penetrate through a lower surface of the first barrier insulating layer BII,1.

In an embodiment, the first metal layer MTL1 may be disposed on the first barrier insulating layer BII,1. The first metal layer MTL1 may include a pad part PAD and a first fan-out line FOL1. The pad part PAD may be integrally formed with the first fan-out line FOL1 and inserted into the first contact hole CNT1.

In an embodiment, the second barrier insulating layer BIL2 may be disposed on the first barrier insulating layer BIL1 and the first metal layer MTL1. The second barrier insulating layer BIL2 may include an inorganic film capable of preventing permeation of air or moisture.

In an embodiment, the second substrate SUB2 may be disposed on the second barrier insulating layer BIL2. The second substrate SUB2 may be a base substrate or a base member.

In an embodiment, the transistor layer TRL may be disposed on the second substrate SUB2. The transistor layer TRL includes a buffer layer BF, an active layer ACTL, a gate insulating layer GI, a second metal layer MTL2, an interlayer insulating layer ILD, a third metal layer MTL3, a passivation layer PAS, and a via layer VIA.

In an embodiment, the second metal layer MTL2 may be disposed on the gate insulating layer GI. The second metal layer MTL2 may include the gate electrode GE of the transistor TR and the second fan-out line FOL2. The third metal layer MTL3 may include a connection part CWL, a connection electrode CNE, a data line DL, and a power line VL.

In an embodiment, the second fan-out line FOL2 may be electrically connected to the first fan-out line FOL1 through the connection part CWL. The second fan-out line FOL2 may be electrically connected to the data line DL or the power line VL of the display area DA, or the scan driver SIC of the non-display area NDA.

In an embodiment, the light emitting element layer EML may be disposed on the transistor layer TRL. The light emitting element layer EML may include a light emitting element ED and a pixel defining film PDL.

In an embodiment, the encapsulation layer TFEL may be disposed on the common electrode CE to cover the plurality of light emitting elements ED.

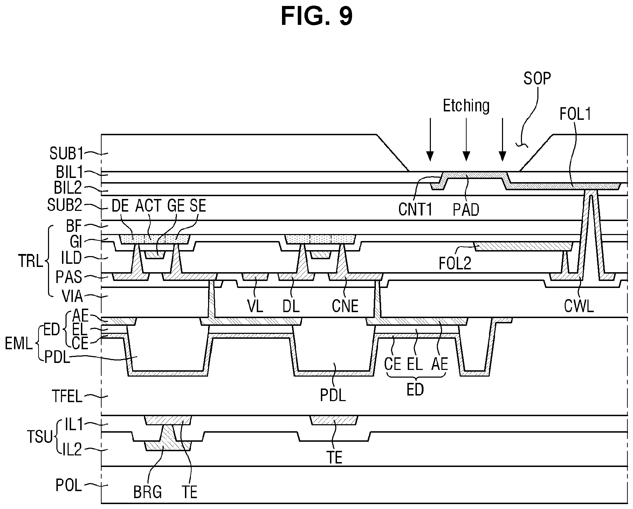

In an embodiment and referring to FIG. 9, the display device 10 under manufacture may be vertically inverted in order to attach the flexible film FPCB.

In an embodiment, one surface of the first substrate SUB1 may be etched to form an open portion SOP. At least one of a wet etching process, a dry etching process, a plasma etching process, and a laser etching process may be performed on one surface of the first substrate SUB1. The open portion SOP may be provided on the first substrate SUB1 to expose the pad part PAD. One open portion SOP may expose a plurality of pad parts PAD, but is not limited thereto.

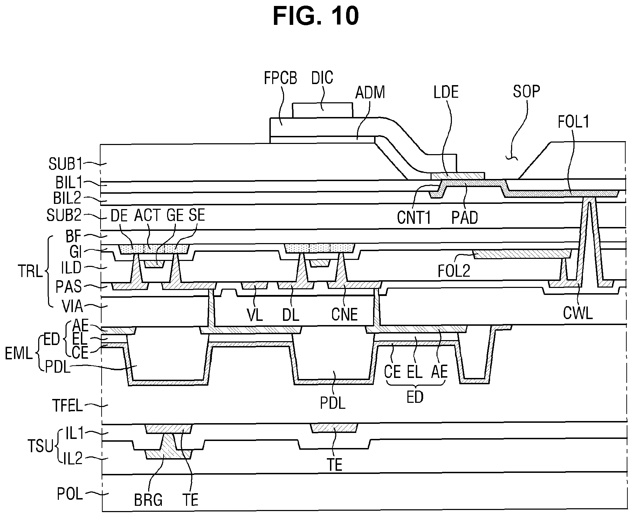

In an embodiment and referring to FIG. 10, the flexible film FPCB may be disposed on one surface of the first substrate SUB 1. The flexible film FPCB and the lead electrode LDE may be aligned on the pad part PAD through an alignment process. One side of the flexible film FPCB may be inserted into the open portion SOP of the first substrate SUB1 and electrically connected to the pad part PAD, and the other side of the flexible film FPCB may be disposed on the lower surface of the first substrate SUB 1 using the support member ADM. In an embodiment, the support member ADM may support the flexible film FPCB by including at least one of a patterned film and a cover panel. The lead electrode LDE may protrude from one side of the flexible film FPCB. For example, one surface of the lead electrode LDE may be fixed to one surface of the pad part PAD through an adhesive layer. In another embodiment, one surface of the lead electrode LDE may be in direct contact with one surface of the pad part PAD.

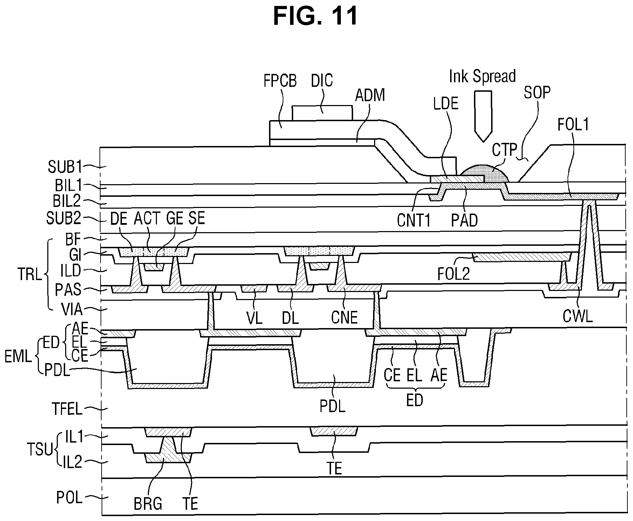

In an embodiment and referring to FIG. 11, the contact part CTP may cover a portion of the lead electrode LDE and a portion of the pad part PAD. A portion of the other surface of the lead electrode LDE may be electrically connected to another portion of the pad part PAD through the contact part CTP.

In an embodiment, the conductive ink may be spread on the lead electrode LDE and the pad part PAD (Ink Spread). The conductive ink may include nanoparticles and polymers. The contact part CTP may be formed by low temperature sintering of the conductive ink.

In an embodiment, the sintered conductive ink, metal paste, or metal organic decomposition ink may cover the plurality of pad parts PAD and the plurality of lead electrodes LDE inserted into one open portion SOP at once, and a plurality of cutting portions CUT formed in the laser patterning process may separate the plurality of contact parts CTP. The contact part CTP may be spaced apart from adjacent contact parts CTP by the plurality of cutting portions CUT, and one contact part CTP may electrically connect one pad part PAD and one lead electrode LDE.

Therefore, in an embodiment, in the display device 10, by electrically connecting the lead electrode LDE and the pad part PAD through the contact part CTP, the lead electrode LDE of the flexible film FPCB may be electrically connected to the pad part PAD without using ultrasonic bonding or thermal compression bonding. In addition, manufacturing time and manufacturing cost may be reduced by simplifying the process of manufacturing the display device 10.

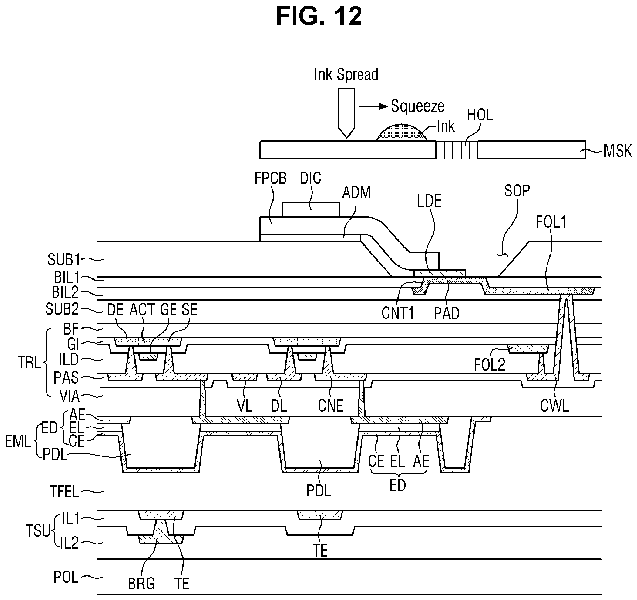

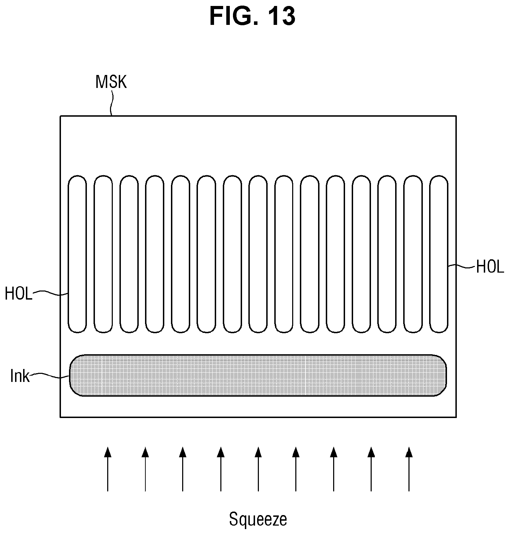

FIG. 12 is a cross-sectional view illustrating another example of a process of manufacturing a display device, according to an embodiment, and FIG. 13 is a plan view illustrating a mask used in the process of manufacturing the display device of FIG. 12, according to an embodiment.

In an embodiment and referring to FIGS. 12 and 13, the plurality of contact parts CTP may be formed by performing a squeeze process using a mask MSK including a plurality of holes HOL on conductive ink, metal paste, or metal organic decomposition ink. The size and spacing of the plurality of holes HOL may be determined by the size and spacing of the pad part PAD. The conductive ink, metal paste, or metal organic decomposition ink may pass through the plurality of holes HOL through a squeeze process, and may be printed on the plurality of pad parts PAD to be spaced apart from each other. The plurality of contact parts CTP may be formed by low temperature sintering of the printed ink. Therefore, the plurality of contact parts CTP may be spaced apart from each other according to a spacing between the plurality of holes, and one contact part CTP may electrically connect one pad part PAD and one lead electrode LDE without a separate patterning process.

The invention should not be construed as being limited to the embodiments set forth herein. Rather, these embodiments are provided so that this invention will be thorough and complete and will fully convey the invention to those skilled in the art. While the invention has been particularly shown and described with reference to embodiments thereof, it will be understood by those of ordinary skill in the art that various changes in form and details may be made therein without departing from the scope of the invention. Moreover, the embodiments or parts of the embodiments may be combined in whole or in part without departing from the scope of the invention.

## Claims

1. A display device (10) comprising:
a first substrate (SUB1) including an open portion (SOP);
a first barrier insulating layer (BII,1) disposed on the first substrate (SUB1) and including a first contact hole (CNT1) overlapping the open portion (SOP);
a first fan-out line (FOL1) disposed on the first barrier insulating layer (BIL1);
a pad part (PAD) integrally formed with the first fan-out line (FOL1) and exposed through the open portion (SOP) by being disposed within the first contact hole (CNT1);
a second substrate (SUB2) disposed on the first fan-out line (FOL1);
a connection part (CWL) disposed on the second substrate (SUB2) and connected to the first fan-out line (FOL1);
a second fan-out line (FOL2) disposed on a layer located between the first fan-out line (FOL1) and the connection part (CWL) and connected to the connection part (CWL);
a data line (DL) disposed on a same layer as the connection part (CWL) and electrically connected to the second fan-out line (FOL2) to supply a data voltage;
a flexible film (FPCB) disposed under the first substrate (SUB1) and including a lead electrode (LDE) disposed within the open portion (SOP) of the first substrate (SUB1); and
a contact part (CTP) electrically connecting the lead electrode (LDE) and the pad part (PAD) by contacting a lower surface of the lead electrode (LDE) and a lower surface of the pad part (PAD).

2. The display device (10) of claim 1, wherein the lead electrode (LDE) protrudes from one side of the flexible film (FPCB), and wherein the contact part (CTP) contacts a lower surface of the lead electrode (LDE) protruding from the flexible film (FPCB).

3. The display device (10) of at least one of claims 1 or 2, further comprising a display area (DA) displaying an image, and a non-display area (NDA) surrounding the display area (DA),
wherein the flexible film (FPCB) is disposed in the display area (DA).

4. The display device (10) of at least one of claim 1 to 3, further comprising a transistor including a drain electrode (DE), a semiconductor area (ACT), a source electrode (SE), and a gate electrode (GE) disposed on an active layer of the first fan-out line (FOL1),
wherein the data line (DL) supplies a data voltage to the transistor.

5. The display device (10) of at least one of claims 1 to 4, further comprising a power line (VL) disposed on a same layer as the data line (DL) to supply a power voltage to the transistor.

6. The display device (10) of at least one of claims 1 to 5, further comprising:
a transistor layer (TRL) including a transistor electrically connected to the data line (DL);
a light emitting element layer (EML) disposed on the transistor layer (TRL) and including a light emitting element; and
an encapsulation layer (TFEL) contacting an upper surface and side surfaces of the light emitting element layer (EML).

7. The display device (10) of at least one of claims 1 to 6, wherein the first substrate (SUB1) and the second substrate (SUB2) include a polyimide or a polymer resin.

8. A display device (10) comprising:
a first substrate (SUB1) including an open portion (SOP);
a first barrier insulating layer (BII,1) disposed on the first substrate (SUB1) and including a first contact hole (CNT1) overlapping the open portion (SOP);
a pad part (PAD) disposed within the first contact hole (CNT1) and exposed through the open portion (SOP);
a first fan-out line (FOL1) disposed on the first barrier insulating layer (BIL1) and integrally formed with the pad part (PAD);
a second substrate (SUB2) disposed on the first fan-out line (FOL1);
a second fan-out line (FOL2) disposed on the second substrate (SUB2) and electrically connected to the first fan-out line (FOL1);
a transistor disposed on the first fan-out line (FOL1) and electrically connected to the second fan-out line (FOL2);
a flexible film (FPCB) disposed under the first substrate (SUB1) and disposed within the open portion (SOP) of the first substrate (SUB1); and
a lead electrode (LDE) protruding from one side of the flexible film (FPCB) and including a portion that does not overlap the flexible film (FPCB).

9. The display device (10) of claim 8, further comprising a contact part (CTP) electrically connecting the lead electrode (LDE) and the pad part (PAD) by contacting a portion of the lead electrode (LDE) that does not overlap the flexible film (FPCB) and one surface of the pad part (PAD).

10. The display device (10) of at least one of claims 1 to 9, wherein the contact part (CTP) is formed by sintering conductive ink, metal paste, or metal organic decomposition ink including silver, copper, aluminum, or chromium.

11. The display device (10) of claim 8 or 9, further comprising:
a data line (DL) disposed on the transistor to supply a data voltage to the transistor; and
a power line (VL) disposed on a same layer as the data line (DL) to supply a power voltage to the transistor.

12. The display device (10) of at least one of claims 1 to 11, further comprising:
a connection electrode (CNE) disposed on the same layer as the data line (DL) and electrically connected to the transistor; and
a pixel electrode (AE) disposed on the connection electrode (CNE) and connected to the connection electrode (CNE) to receive a driving current from the transistor.

13. A method of manufacturing a display device (10), in particular a display device of at least one of claims 1 to 12, the method comprising:
preparing a first substrate (SUB1);
forming a first barrier insulating layer (BIL1) including a first contact hole (CNT1) on the first substrate (SUB1);
forming a first fan-out line (FOL1) disposed on the first barrier insulating layer (BII,1) and a pad part (PAD) integrally formed with the first fan-out line (FOL1) and disposed within the first contact hole (CNT1);
forming a second substrate (SUB2) on the pad part (PAD);
forming a second fan-out line (FOL2) disposed on the second substrate (SUB2);
forming a connection part (CWL) disposed on the second fan-out line (FOL2) to electrically connect the first fan-out line (FOL1) and the second fan-out line (FOL2);
forming an open portion (SOP) which exposes the pad part (PAD) by etching a lower portion of the first substrate (SUB1);
inserting a lead electrode (LDE) of a flexible film (FPCB) into the open portion (SOP) and fixing the lead electrode (LDE) to one surface of the pad part (PAD); and
forming a contact part (CTP) electrically connecting the pad part (PAD) and the lead electrode (LDE) by contacting a portion of the pad part (PAD) and a portion of the lead electrode (LDE).

14. The method of claim 13, wherein the forming of the contact part (CTP) includes:
printing at least one of conductive ink, metal paste, or metal organic decomposition ink including silver, copper, aluminum, or chromium on the open portion (SOP) of the first substrate (SUB1); and
sintering the at least one conductive ink, metal paste, or metal organic decomposition ink to create at least one of sintered conductive ink, sintered metal paste or sintered metal organic decomposition ink.

15. The method of claim 13 or 14, wherein the forming of the contact part (CTP) further includes separating the at least one sintered conductive ink, sintered metal paste, or sintered metal organic decomposition ink into a plurality of contact parts (CTP) through a laser patterning process.

16. The method of at least one of claims 13 to 15, wherein the sintering of at least one of the conductive ink, the metal paste, or the metal organic decomposition ink includes aggregating metal particles by applying heat generated by light pulse or laser.

17. The method of at least one of claims 13 to 16, wherein the forming of the contact part (CTP) includes:
printing conductive ink, metal paste, or metal organic decomposition ink on the open portion (SOP) of the first substrate (SUB1) by performing a squeeze process using a mask including a plurality of holes; and
sintering at least one of the conductive ink, the metal paste, or the metal organic decomposition ink.

18. The method of at least one of claims 13 to 17, wherein a size and a spacing of the plurality of holes are determined by a size and a spacing of the pad part (PAD).
